# EUROPEAN PATENT APPLICATION

(11) **EP 4 672 884 A1**
(43) Date of publication of application: **31.12.2025**
(21) Application number: 24214659.5
(22) Date of filing: 21.11.2024
(51) Int. Cl.: H05K 7/20

(54) **HEAT DISSIPATION DEVICE**

(30) Priority: 24.06.2024 CN 202410816512
(71) Applicant: Zhejiang Jinko Energy Storage Co., Ltd., Jiaxing, Zhejiang (CN)
(72) Inventor: ZHANG, Luhua, Haining (CN); YU, Jian, Haining (CN)
(74) Representative: Balder IP Law, S.L.

(57) **Abstract**

A heat dissipation device is provided. The heat dissipation device is configured to dissipate heat from a plurality of heating elements, each heating element of the plurality of heating elements includes a respective plurality of heating units, the heat dissipation device includes: a liquid-cooling plate and a plurality of heat pipes arranged in a plurality of heat pipe assemblies, and each heat pipe assembly of the plurality of heat pipe assemblies includes at least one respective heat pipe. A respective heat pipe assembly of the plurality of heat pipe assemblies is configured to be in contact with at least one corresponding heating element of the plurality of heating elements. Each heat pipe of the respective heat pipe assembly is configured to be in contact with at least one heating unit of the at least one corresponding heating element.

## Description

### TECHNICAL FIELD

The present disclosure relates to the technical field of heat dissipation of heating elements, and in particular to a heat dissipation device.

### BACKGROUND

At present, a heating element in the market is cooled by air-cooling. However, on the one hand, the cooling effect of air cooling is poor, on the other hand, when the air-cooling structure is applied to a box with a limited space, it is difficult to adapt to the space of the box.

### SUMMARY

An object according to embodiments of the present disclosure is to provide a heat dissipation device, so as to solve the problem of poor cooling effect of an existing air-cooling method.

In order to solve the above problem, in an aspect, a heat dissipation device for an energy storage converter is configured to dissipate heat from a plurality of heating element, each heating element of the plurality of heating elements includes a respective plurality of heating units, the heat dissipation device includes: a liquid-cooling plate and a plurality of heat pipes arranged in a plurality of heat pipe assemblies, and each heat pipe assembly of the plurality of heat pipe assemblies includes at least one respective heat pipe. A respective heat pipe assembly of the plurality of heat pipe assemblies is configured to be in contact with at least one corresponding heating element of the plurality of heating elements. Each heat pipe of the respective heat pipe assembly is configured to be in contact with at least one heating unit of the at least one corresponding heating element, each heating unit of the at least one corresponding heating element is in contact with at least one heat pipe of the respective heat pipe assembly. The liquid-cooling plate includes a liquid-cooling flow channel, and at least a portion of each heat pipe of the plurality of heat pipes is in thermal contact with the liquid-cooling flow channel and configured to transfer heat generated by the plurality of heating elements to the liquid-cooling flow channel.

In an embodiment, each heat pipe of the plurality of heat pipes has at least one of a configurable length or a configurable width, to enable control a temperature difference between every two heating units within a preset range of each other among the plurality of heating units.

According to the heat dissipation device of the embodiments of the present disclosure, the heat pipe is simultaneously in contact with both the heating element and the liquid-cooling flow channel, so that heat generated by the heating element is transferred from the heat pipe to a coolant inside the liquid-cooling flow channel and is taken out of the liquid-cooling plate with the flow of the coolant, thereby realizing effective heat dissipation of the heating element. In addition, the length and/or the width of the respective heat pipe is adjusted, so that the temperature difference between every two heating units of the plurality of heating units is within the preset range. Compared to the air-cooling method, the heat dissipation device has a good cooling effect without occupying too much space.

In an embodiment, the plurality of heat pipe assemblies are arranged at intervals along a flowing direction of liquid in the liquid-cooling flow channel, and the one respective heat pipe assembly of the plurality of heat pipe assemblies is arranged in contact with a same number of corresponding heating elements of the plurality of heating elements.

In an embodiment, the liquid-cooling flow channel includes a plurality of main flow channels arranged at intervals and at least one connecting flow channel, every two adjacent main flow channels are in communication with each other through one respective connecting flow channel, each respective main flow channel of the plurality of main flow channels is provided with at least one corresponding heat pipe assembly of the plurality of heat pipe assemblies, and at least a portion of each heat pipe of heat pipes of the at least one corresponding heat pipe assembly is in contact with the each respective main flow channel.

In an embodiment, the liquid-cooling flow channel includes a first main flow channel, a second main flow channel, a third main flow channel and a fourth main flow channel, and includes a first connecting flow channel, a second connecting flow channel and a third connecting flow channel. The first connecting flow channel is connected between the first main flow channel and the second main flow channel, the second connecting flow channel is connected between the second main flow channel and the third main flow channel, and the third connecting flow channel is connected between the third main flow channel and the fourth main flow channel. The first main flow channel is configured to feed the liquid, and the fourth main flow channel is configured to discharge the liquid. Each of the first main flow channel, the second main flow channel and the third main flow channel is provided with at least one corresponding heat pipe assembly of the plurality of heat pipe assemblies.

In an embodiment, the plurality of heat pipe assemblies include a first heat pipe assembly, a second heat pipe assembly and a third heat pipe assembly. The first main flow channel is provided with the first heat pipe assembly, the second main flow channel is provided with the second heat pipe assembly, and the third main flow channel is provided with the third heat pipe assembly.

In an embodiment, the plurality of heating elements include a first heating element, a second heating element and a third heating element. The first heat pipe assembly is arranged in contact with the first heating element, the second heat pipe assembly is arranged in contact with the second heating element, and the third heat pipe assembly is arranged in contact with the third heating element.

In an embodiment, the first main flow channel, the second main flow channel, the third main flow channel and the fourth main flow channel are arranged at intervals along a preset direction. The respective plurality of heating units arranged on each heating element of the plurality of heating elements are arranged in a single row along the preset direction. Each heat pipe assembly of the plurality of heat pipe assemblies includes a plurality of heat pipes arranged at intervals along the preset direction, and a number of heat pipes of each heat pipe assembly of the plurality of heat pipe assemblies is equal to a number of heating units on each heating element of the plurality of heating elements. Heat pipes of the one respective heat pipe assembly of the plurality of heat pipe assemblies are arranged in one-to-one contact with heating units on a corresponding heating element of the plurality of heating elements.

In an embodiment, two heating units are arranged on each heating element of the plurality of heating elements, and each heat pipe assembly of the plurality of heat pipe assemblies includes two heat pipes. One heat pipe of the first heat pipe assembly closer to the second main flow channel has a length greater than a length of an other heat pipe of the first heat pipe assembly. One heat pipe of the second heat pipe assembly closer to the third main flow channel has a length greater than a length of an other heat pipe of the second heat pipe assembly closer to the first main flow channel. One heat pipe of the third heat pipe assembly closer to the fourth main flow channel has a length less than a length of an other heat pipe of the third heat pipe assembly closer to the third main flow channel.

In an embodiment, three or more heating units are arranged on each heating element of the plurality of heating elements, and each heat pipe assembly of the plurality of heat pipe assemblies includes three or more heat pipes. A heat pipe of the first heat pipe assembly closest to the second main flow channel has a length greater than a length of a heat pipe of the first heat pipe assembly most far away from the second main flow channel, and a remaining heat pipe of the first heat pipe assembly has a length greater than the length of the heat pipe closest to the second main flow channel. One heat pipe of every two adjacent heat pipes of the second heat pipe assembly closer to the third main flow channel has a length greater than or equal to a length of an other heat pipe closer to the first main flow channel. One heat pipe of every two adjacent heat pipes of the third heat pipe assembly closer to the fourth main flow channel has a length less than a length of an other heat pipe closer to the third main flow channel.

In an embodiment, a heat pipe of the second heat pipe assembly closer to the first main flow channel has a length greater than or equal to a length of a heat pipe of the first heat pipe assembly farther away from the second main flow channel. A heat pipe of the second heat pipe assembly closer to the third main flow channel has a length greater than a length of a heat pipe of the first heat pipe assembly closer to the second main flow channel. A heat pipe of the third heat pipe assembly closer to the second main flow channel has a length greater than a length of a heat pipe of the second heat pipe assembly closer to the third main flow channel. A heat pipe of the third heat pipe assembly closer to the fourth main flow channel has a length less than a length of a heat pipe of the second heat pipe assembly closer to the third main flow channel.

In an embodiment, a heat pipe of the second heat pipe assembly closer or closest to the first main flow channel has a length greater than or equal to a length of a heat pipe of the first heat pipe assembly more or most far away from the second main flow channel. A heat pipe of the second heat pipe assembly closer or closest to the third main flow channel has a length greater than a length of a heat pipe of the first heat pipe assembly closer or closest to the second main flow channel. A heat pipe of the third heat pipe assembly closer or closest to the second main flow channel has a length greater than a length of a heat pipe of the second heat pipe assembly closer or closest to the third main flow channel. A heat pipe of the third heat pipe assembly closer or closest to the fourth main flow channel has a length less than a length of a heat pipe of the second heat pipe assembly closer or closest to the third main flow channel.

In an embodiment, each heating element of the plurality of heating elements is provided with a first heating unit, a second heating unit and a third heating unit arranged at intervals along the preset direction in a single row. Each heat pipe assembly of the plurality of heat pipe assemblies includes a first heat pipe, a second heat pipe and a third heat pipe arranged at intervals along the preset direction. The first heating unit of the one respective heat pipe assembly of the plurality of heat pipe assemblies is in contact with the first heat pipe of one corresponding heating element of the plurality of heating elements, the second heating unit of the one respective heat pipe assembly is in contact with the second heat pipe of the one corresponding heating element, and the third heating unit of the one respective heat pipe assembly is in contact with the third heat pipe of the one corresponding heating element. The third heat pipe of the first heat pipe assembly has a length greater than a length of the first heat pipe of the first heat pipe assembly, and the second heat pipe of the first heat pipe assembly has a length greater than the length of the third heat pipe of the first heat pipe assembly. The second heat pipe of the second heat pipe assembly has a length greater than or equal to a length of the first heat pipe of the second heat pipe assembly, and the third heat pipe of the second heat pipe assembly has a length greater than the length of the second heat pipe of the second heat pipe assembly. The third heat pipe of the third heat pipe assembly has a length less than a length of the second heat pipe of the third heat pipe assembly, and the first heat pipe of the third heat pipe assembly has a length greater than or equal to the length of the second heat pipe of the third heat pipe assembly. The length of the first heat pipe of the second heat pipe assembly is greater than or equal to the length of the first heat pipe of the first heat pipe assembly. The length of the third heat pipe of the second heat pipe assembly is greater than the length of the third heat pipe of the first heat pipe assembly. The length of the first heat pipe of the third heat pipe assembly is greater than the length of the third heat pipe of the second heat pipe assembly. The length of the third heat pipe of the third heat pipe assembly is less than the length of the third heat pipe of the second heat pipe assembly.

In an embodiment, the plurality of heating elements are arranged in multiple rows and multiple columns, a number of the plurality of heat pipe assemblies is equal to a number of the plurality of the heating elements, and the plurality of the heat pipe assemblies are in one-to-one correspondence with the plurality of heating elements. Each respective main flow channel of the plurality of main flow channels is provided with at least two corresponding heat pipe assemblies of the plurality of heat pipe assemblies. Each heat pipe of a heat pipe assembly of the at least two corresponding heat pipe assemblies closer or closest to a liquid outlet of the liquid-cooling flow channel has a respective length greater than or equal to a respective length of each heat pipe of a heat pipe assembly of the at least two corresponding heat pipe assemblies closer or closest to a liquid inlet of the liquid-cooling flow channel.

In an embodiment, each main flow channel of the plurality of main flow channels has an extending direction same as or intersecting with an extending direction of the at least one respective heat pipe of each heat pipe assembly of the plurality of heat pipe assemblies.

In an embodiment, the plurality of heating elements are arranged in rows and columns. A number of the plurality of heat pipe assemblies is equal to a number of the columns of the plurality of heating elements. Heating elements of the plurality of heating elements in a same column are arranged in contact with a corresponding heat pipe assembly of the plurality of heat pipe assemblies, and each heat pipe assembly of the plurality of heat pipe assemblies is arranged in contact with one respective column of heating elements.

In an embodiment, the respective plurality of heating units arranged on each heating element of the plurality of heating elements are arranged in rows and columns. A number of the at least one respective heat pipes of each heat pipe assembly of the plurality of heat pipe assemblies is equal to a number of the columns of the respective plurality of heating units arranged on each heating element of the plurality of heating elements. Each column of heating units arranged on the at least one corresponding heating element of the plurality of heating elements is in contact with one respective heat pipe of the one respective heat pipe assembly of the plurality of heat pipe assemblies, and each heat pipe of the one respective heat pipe assembly is in contact with one respective column of heating units arranged on the at least one corresponding heating element.

In an embodiment, each heat pipe of the at least one respective heat pipe has a straight shape, a curved shape or a bent shape.

In an embodiment, each heat pipe of the at least one respective heat pipe is embedded in the liquid-cooling plate.

In an embodiment, each connecting flow channel of at least one connecting flow channel has a bent shape.

### BRIEF DESCRIPTION OF THE DRAWINGS

FIG. 1 is a schematic diagram of a heat dissipation device according to some embodiments of the present disclosure;
FIG. 2 is a thermal simulation image of the heat dissipation device in FIG. 1;
FIG. 3 is a thermal simulation image of the heat dissipation device in FIG. 1 viewed from another perspective;
FIG. 4 is a schematic diagram of the heat dissipation device according to some embodiments of the present disclosure;
FIG. 5 is a schematic diagram of the heat dissipation device according to some embodiments of the present disclosure;
FIG. 6 is a schematic diagram of the heat dissipation device according to some embodiments of the present disclosure;
FIG. 7 is a schematic diagram of the heat dissipation device according to some embodiments of the present disclosure;
FIG. 8 is a thermal simulation image of an existing present heat dissipation device; and
FIG. 9 is a thermal simulation image of the existing heat dissipation device viewed from another perspective.

### The reference numerals in the specification are listed as follows:

| | | | |
|---|---|---|---|
| 1, | liquid-cooling plate; | 11, | liquid-cooling flow channel; |
| 111, | main flow channel; | 111a, | first main flow channel; |
| 111b, | second main flow channel; | 111c, | third main flow channel; |
| 111d, | fourth main flow channel; | 112, | connecting flow channel; |
| 112a, | first connecting flow channel; | 112b, | second connecting flow channel; |
| 112c, | third connecting flow channel; | | |
| 2, | heat pipe assembly; | 2a, | first heat pipe assembly; |
| 2b, | second heat pipe assembly; | 2c, | third heat pipe assembly; |
| 21, | heat pipe; | 21a, | first heat pipe; |
| 21b, | second heat pipe; | 21c, | third heat pipe; |
| 3, | heating element; | 3a, | first heating element; |
| 3b, | second heating element; | 3c, | third heating element; |
| 31, | heating unit; | 31a, | first heating unit; |
| 31b, | second heating unit; | 31c, | third heating unit. |

### DETAILED DESCRIPTION OF THE EMBODIMENTS

The technical solutions in the embodiments of the present disclosure are described clearly and completely in conjunction with the drawings of the embodiments of the disclosure hereinafter. It is apparent that the described embodiments are only some rather than all embodiments of the present disclosure. Any other embodiments obtained by those skilled in the art based on the embodiments in the present disclosure without any creative effort shall fall within the protection scope of the present disclosure.

It should be noted that if the embodiments of the present disclosure involve directional indications (such as up, down, left, right, front, back, etc.), the directional indications are only used to explain the relative positional relationship and movement between various component in a certain posture (as shown in the attached figure), and the directional indications are changed accordingly if the certain attitude is changed.

In addition, if the embodiments of the present disclosure involve description of "first", "second", etc., the description of "first", "second", etc. are used only for descriptive purposes, and cannot be understood as indicating or implying their relative importance or implicitly specifying the number of indicated technical features. Accordingly, a feature defined with "first" or "second" can include at least one such feature either explicitly or implicitly. In addition, the technical solutions between the embodiments can be combined with each other based on the realization by those skilled in the art. When the combination of technical solutions is contradictory or unable to be realized, it should be considered that the combination of such technical solutions does not exist, and is not within in the protection scope claimed by the present disclosure.

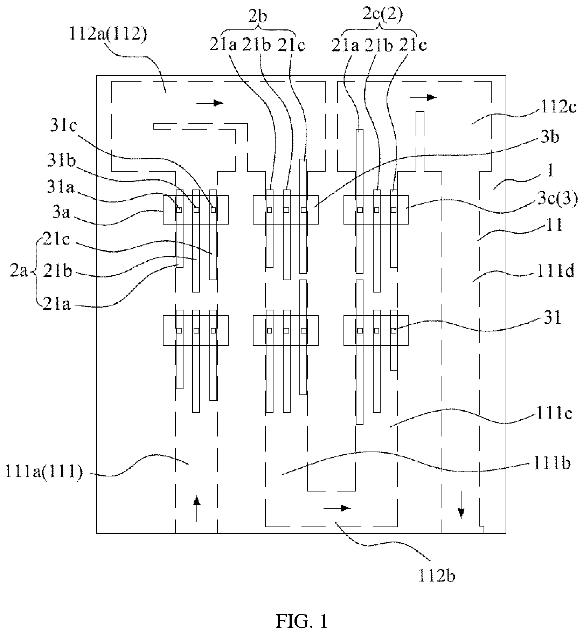

As shown in FIG. 1 to FIG. 7, an energy storage apparatus is provided according to the present disclosure, which includes a plurality of heating elements 3 and a heat dissipation device configured to dissipate heat from the plurality of heating elements 3. Each heating element 3 of the plurality of heating elements 3 includes a respectively plurality of heating units 31. The heat dissipation device includes a liquid-cooling plate 1 and a plurality of heat pipes 31 arranged in a plurality of heat pipe assemblies 2. Each heat pipe assembly 2 of the plurality of heat pipe assemblies 2 includes at least one respective heat pipe 21. A respective heat pipe assembly 2 of the plurality of heat pipe assemblies 2 is configured to be in contact with at least one corresponding heating element 3 of the plurality of heating elements 3.

Each heat pipe 21 of the one respective heat pipe assembly 2 of the plurality of heat pipe assemblies 2 is configured to be in contact with at least one heating unit 31 of the at least one corresponding heat element 3, and each heating unit 31 of the at least one corresponding heating unit 31 is in contact with at least one heat pipe 21 of the respective heat pipe assembly 2, so as to ensure that the heat of each heating unit 31 is dissipated by the at least one heat pipe 21.

The liquid-cooling plate 1 includes a liquid-cooling flow channel 11, and at least a portion of each heat pipe of the plurality of heat pipes 21 is in thermal contact with the liquid-cooling flow channel 11 and configured to transfer heat generated by the plurality of heating elements 3 to the liquid-cooling flow channel 11.

Each heat pipe 21 of the plurality of heat pipes 21 has at least one of a configurable length or a configurable width, to enable control a temperature difference between every two heating units 31 within a preset range of each other among the plurality of heating units 31.

According to the heat dissipation device and the energy storage apparatus of the embodiments of the present disclosure, the heat pipe 21 is simultaneously in contact with both the heating element 3 and the liquid-cooling flow channel 11, so that heat generated by the heating element 3 is transferred from the heat pipe 3 to a coolant inside the liquid-cooling flow channel 11 and is taken out of the liquid-cooling plate 11 with the flow of the coolant, thereby realizing effective heat dissipation of the heating element 3. In addition, the length and/or the width of each respective heat pipe of the plurality of heat pipes 21 is adjusted, so that the temperature difference between every two heating elements 31 among the plurality of heating units 31 is within the preset range. Compared to the air-cooling method, the heat dissipation device has a good cooling effect without occupying too much space.

Further, since temperatures of the heating elements 3 at different positions on the liquid-cooling flow channel 11 are different, and the heat pipe 21 has a high thermal conductivity, the greater the value of the length and/or the width of the heat pipe 21 is, the better the heat dissipation effect on the heating element 3 is. Coupled with the heat exchange between the heat pipe 21 and the coolant in the liquid-cooling flow channel 11, the greater the length and/or the width of the heat pipe 21 is, the better the cooling effect is. Therefore, the temperature difference between every two of the same heating units 31 located on the plurality of heating elements 3 can be adjusted by adjusting the length and/or width of the heat pipe 21, so that the temperature difference between every two of the same the heating units 31 located on the plurality of heating elements 3 is within a preset range, thereby ensuring the uniformity of the cooling and ensuring the stable operation of the plurality of heating elements 3.

When the length of the heat pipe 21 is adjusted, the longer the heat pipe 21 is, the more heat corresponding to the heating unit 31 that the heat pipe 21 can absorb is, and the more heat that can be transferred to the coolant in the liquid-cooling flow channel 11 is, thereby increasing the efficiency of thermal conduction.

When the width of the heat pipe 21 is adjusted, the wider the heat pipe 21 is, the greater the contact area between the heat pipe 21 and the corresponding heating unit 31 is, which is directly proportional to the efficiency of thermal conduction of the heat pipe 21.

It should be noted that the length of the heat pipe 21 refers to the length of the heat pipe 21 along an axial direction of the heating unit 31, and the width of the heat pipe 21 refers to the width of the heat pipe 21 along a direction perpendicular to the axial direction of the heating unit 31.

In an embodiment, the energy storage apparatus is an energy storage converter. The heating unit 31 may be a wafer.

In an embodiment, the heat pipe 21 is embedded in the liquid-cooling plate 1, to be in contact with the liquid-cooling flow channel 11. Specifically, in order to ensure that the heat pipe 21 is simultaneously in contact with both the heating element 3 and the liquid-cooling flow channel 11, a portion of the heat pipe 21 is embedded in the liquid-cooling plate 1 to be in contact with the liquid-cooling flow channel 11 and another portion of the heat pipe 21 is exposed to the liquid-cooling plate 1 to be in contact with the heating element 3.

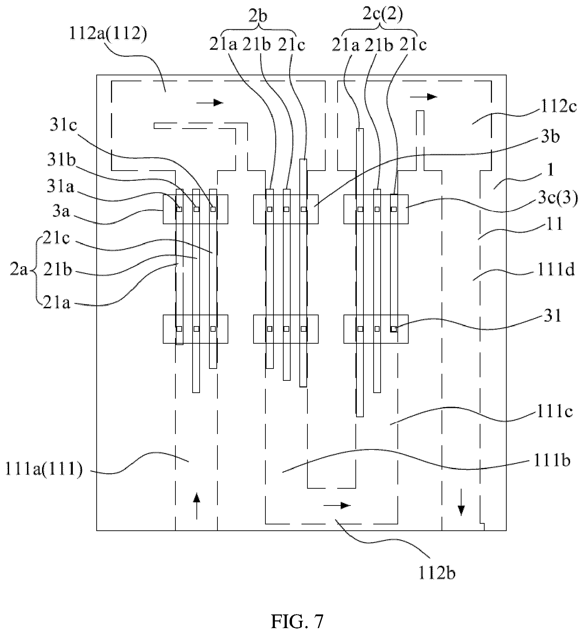

In an embodiment, the plurality of the heating elements 3 are arranged in one-to-one correspondence with the plurality of the heat pipe assemblies 2 (taking the embodiments shown in FIG. 1, FIG. 4 to FIG. 6 as examples). In this case, a single heat pipe assembly 2 can cool a corresponding single heating element 3. Alternatively, a single heat pipe assembly 2 is arranged in contact with a plurality of the heating elements 3 (taking the embodiment shown in FIG. 7 as an example). In this case, the same heat pipe assembly 2 can simultaneously cool the plurality of the heating elements 3, thereby improving the integration of the heat dissipation device.

In an embodiment, the plurality of the heating elements 3 are arranged in rows and columns. The number of the heat pipe assemblies 2 is equal to the number of columns of the heating elements 3.

Heating elements 3 in a same column are arranged in contact with a same heat pipe assembly 2, and each heat pipe assembly 2 is arranged in contact with one respective column of heating elements 3, so that the plurality of heating elements 3 can be in contact with the corresponding heat pipe assemblies 2, thereby ensuring the cooling of the heating elements 3.

In an embodiment, the plurality of heating units 31 on each of the plurality of heating elements 3 are arranged in rows and columns. The number of the heat pipes 21 of each heat pipe assembly 2 is equal to the number of columns of the heating units 31 on each heating element 3.

Each column of heating units 31 arranged on the at least one corresponding heating element 3 of the plurality of heating elements 3 is in contact with one respective heat pipe 21 of the plurality of heat pipe assemblies 2, and each heat pipe 21 of the one respective heat pipe assembly 2 is contact with one respective column of heating units 31 arranged on the at least one corresponding heating element 3, so that the heating units 31 on the heating elements 3 can be in contact with the heat pipes 21, thereby ensuring the cooling of the heating units 31.

In an embodiment, the plurality of the heat pipe assemblies 2 are arranged at intervals along a flow direction of liquid in the liquid-cooling flow channel 11, and each heat pipe assembly 2 is arranged in contact with a same number of corresponding heating elements 3, to realize heat dissipation of the plurality of heating elements 3.

In an embodiment, the preset range is 0 to 3°C.

In an embodiment, the liquid-cooling flow channel 11 includes a plurality of main flow channels 111 and at least one connecting flow channel 112, the plurality of the main flow channels 111 are arranged at intervals, and every two adjacent the main flow channels 111 are in communication with each other through one connecting flow channel 112, each of the main flow channels 111 is provided with at least one corresponding heat pipe assembly 2, and at least a portion of each heat pipe 21 of each respective heat pipe assembly 2 is in contact with the corresponding the main flow channel 111, so as to ensure that the heat of each heat pipe 21 can be transferred to the corresponding the main flow channel 111, and then be taken out of the liquid-cooling plate 1 with the coolant in the liquid-cooling flow channel 11.

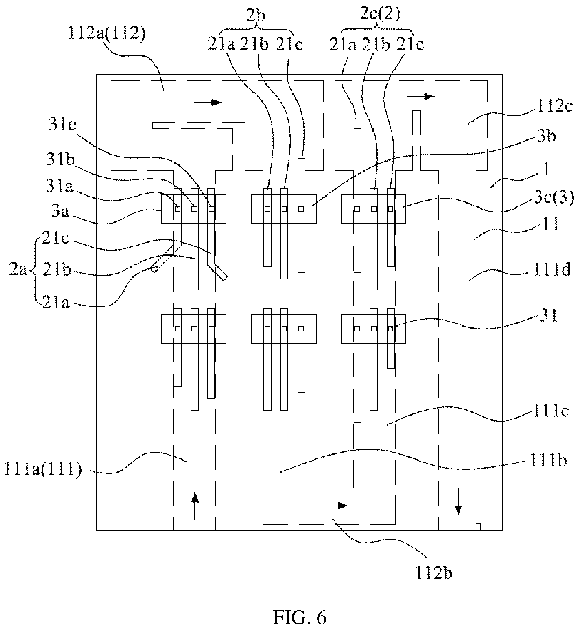

In an embodiment, each main flow channel 111 of the plurality of main flow channels 11 has an extending direction same as (taking the embodiments shown in FIG. 1, FIG. 4, FIG. 5, and FIG. 7 as examples) or intersecting with (taking the embodiment shown in FIG. 6 as an example) an extending direction of the at least one respective heat pipe 21 of each heat pipe assembly 2 of the plurality of heat pipe assemblies 2, thus realizing the heat transfer between the heat pipe 21 and the liquid-cooling flow channel 11 while forming the heat dissipation device.

In an embodiment, the connecting flow channel 112 has a bent structure, which can increase the flow path of the coolant, thus increasing the cooling effect of the liquid-cooling plate 1.

In an embodiment, the heat pipe 21 is a straight heat pipe (taking the embodiments shown in FIG. 1, FIG. 4 and FIG. 7 as examples), a curved heat pipe or a bent heat pipe (taking the embodiment shown in FIG. 6 as an example), so as to realize heat transfer. The shape of the heat pipe 21 can be set according to the actual needs, and is not limited herein.

The heat dissipation device according to the present disclosure is described in the following embodiments.

As shown in FIG. 1, in some embodiments of the present disclosure, six heating elements 3 are provided, and the six heating elements 3 are arranged in multiple rows and multiple columns in a manner of 2 (rows) * 3 (columns), including two first heating elements 3a in a first column, two second heating elements 3b in a second column, and two third heating elements 3c in a third column.

Three heating units 31 are provided on each heating element 3, and the three heating units 31 on the same heating element 3 are arranged in a single row and multiple columns in a manner of 1 (row) * 3 (columns), which may include two first heating units 31a, two second heating units 31b, and one third heating unit 31c.

The number of the heat pipe assemblies 2 is equal to the number of the heating elements 3, six heat pipe assemblies 2 are provided, and the six heat pipe assemblies 2 can be referred to as two first heat pipe assemblies 2a, two second heat pipe assemblies 2b, and two third heat pipe assemblies 2c, respectively. The first heat pipe assemblies 2a, the second heat pipe assemblies 2b, and the third heat pipe assemblies 2c are arranged at intervals along the flow direction of the liquid in the liquid-cooling flow channel 11 (referring to a direction indicated by an arrow in the figure). The plurality of the heat pipe assemblies 2 are arranged in one-to-one correspondence with the plurality of the heating elements 3, i.e., each of the heat pipe assemblies 2 is arranged in contact with one of the heating elements 3. Specifically, the first heat pipe assemblies 2a are arranged in one-to-one correspondence with the two first heating elements 3a, the second heat pipe assemblies 2b are arranged in one-to-one correspondence with the two second heating elements 3b, and the third heat pipe assemblies 2c are arranged in one-to-one correspondence with the two third heating elements 3c.

Each of the heat pipe assemblies 2 includes three heat pipes 21, which are referred to as a first heat pipe 21a, a second heat pipe 21b, and a third heat pipe 21c, respectively.

The first heat pipe 21a of the first heat pipe assembly 2a is in contact with the corresponding first heating unit 31a of the first heating element 3a, and the second heat pipe 21b of the first heat pipe assembly 2a is in contact with the corresponding second heating unit 31b of the first heating element 3a, and the third heat pipe 21c of the first heat pipe assembly 2a is in contact with the corresponding third heating unit 31c of the first heating element 3a.

The first heat pipe 21a of the second heat pipe assembly 2b is in contact with the corresponding first heating unit 31a of the second heating element 3b, the second heat pipe 21b of the second heat pipe assembly 2b is in contact with the corresponding second heating unit 31b of the second heating element 3b, and the third heat pipe 21c of the second heat pipe assembly 2b is in contact with the corresponding third heating unit 31c of the second heating element 3b.

The first heat pipe 21a of the third heat pipe assembly 2c is in contact with the corresponding first heating unit 31a of the third heating element 3c, the second heat pipe 21b of the third heat pipe assembly 2c is in contact with the corresponding second heating unit 31b of the third heating element 3c, and the third heat pipe 21c of the third heat pipe assembly 2c is in contact with the corresponding third heating unit 31c of the third heating element 3c.

It should be noted that although the heating elements in FIG. 1 include the first heating elements 3a, the second heating elements 3b, and the third heating elements 3c, which is only a schematic illustration, and does not constitute a limitation on the number of heating elements in the energy storage apparatus provided by the present disclosure.

As shown in FIG. 1, the liquid-cooling flow channel 11 includes four main flow channel 111 and three connecting flow channels 112. The four main flow channels 111 are referred to as a first main flow channel 111a, a second main flow channel 111b, a third main flow channel 111c and a fourth main flow channel 111d, respectively. The three connecting flow channels 112 are referred to as a first connecting flow channel 112a, a second connecting flow channel 112b and a third connecting flow channel 112c.

The first main flow channel 111a, the second main flow channel 111b, the third main flow channel 111c and the fourth main flow channel 111d are arranged at intervals and parallel to each other along the preset direction, and the three heating units 31 on each heating element 3 are also arranged at intervals along the preset direction. The first main flow channel 111a and the second main flow channel 111b are in communication with each other through the first connecting flow channel 112a, the second main flow channel 111b and the third main flow channel 111c are in communication with each other through the second connecting flow channel 112b, and the third main flow channel 111c and the fourth main flow channel 111d are in communication with each other through the third connecting flow channel 112c. The first main flow channel 111a is configured to feed liquid and the fourth main flow channel 111d is configured to discharge liquid, so as to form the liquid-cooling flow channel 11.

The two first heat pipe assemblies 2a are arranged in the first main flow channel 111a, the two second heat pipe assemblies 2b are arranged in the second main flow channel 111b, and the two third heat pipe assemblies 2c are arranged in the third main flow channel 111c, so as to ensure that the heat from each heat pipe 21 can be transferred to the main flow channel 111, and then the heat from the liquid-cooling pipe 21 can be transferred to the corresponding main flow channel 111, and then be taken out of the liquid-cooling plate 1 with the coolant in the liquid-cooling flow channel 11.

As shown in FIG. 1, the heat pipes 21 are straight pipes, each main flow channel 111 has an extending direction same as an extending direction of each heat pipe 21, and the heat pipes 21 are in contact with the liquid-cooling flow channel 11, so as to realize heat transfer between the heat pipes 21 and the liquid-cooling flow channel 11.

As shown in FIG. 1, the heat pipe assemblies 2 and the main flow channels 111 are arranged in a "two-to-one" manner, i.e., two corresponding heat pipe assemblies 2 are arranged in each of the main flow channels 111. The heat pipe assemblies 2 and the heating elements 3 are arranged in a one-to-one manner, i.e., each heat pipe assembly 2 is arranged in contact with one corresponding heating element 3. The heat pipes 21 of the heat pipe assembly 2 are in one-to-one correspondence with the heating units 31 of the heating element 3, that is, each heat pipe 21 is in contact with one corresponding heating unit 31.

By adjusting a length of each heat pipe 21, the temperature difference between every two heating units 31 is within the preset range.

As shown in FIG. 1, in the first heat pipe assembly 2a, a length of the third heat pipe 21c is greater than a length of the first heat pipe 21a, and a length of the second heat pipe 21b is greater than the length of the third heat pipe 21c.

In the second heat pipe assembly 2b, a length of the second heat pipe 21b is not less than a length of the first heat pipe 21a, and a length of the third heat pipe 21c is greater than the length of the second heat pipe 21b.

In the third heat pipe assembly 2c, a length of the third heat pipe 21c is less than a length of the second heat pipe 21b, and the length of the second heat pipe 21b is less than a length of the first heat pipe 21a.

The length of the first heat pipe 21a of the second heat pipe assembly 2b is not less than the length of the first heat pipe 21a of the first heat pipe assembly 2a. The length of the third heat pipe 21c of the second heat pipe assembly 2b is greater than the length of the third heat pipe 21c of the first heat pipe assembly 21a.

The length of the first heat pipe 21a of the third heat pipe assembly 2c is greater than the length of the third heat pipe 21c of the second heat pipe assembly 2b.

The length of the third heat pipe 21c of the third heat pipe assembly 2c is less than the length of the third heat pipe 21c of the second heat pipe assembly 2b.

By setting the length of each heat pipe 21, the temperature difference between every two heating units 31 is within the preset range.

Further, a temperature of the coolant close to a liquid outlet of the liquid-cooling flow channel 11 is generally higher than a temperature of the coolant close to a liquid inlet of the liquid-cooling flow channel 11 in the same the main flow channel 11. Therefore, between the plurality of the heat pipe assemblies 2 in the same the main flow channel 111, the length of the heat pipe 21 of the heat pipe assembly 2 close to the liquid outlet of the liquid-cooling flow channel 11 is not less than the length of the heat pipe 21 of the heat pipe assembly 2 close to the liquid inlet of the liquid-cooling flow channel 11, so that the temperature difference between every two heating units 31 in the same main flow channel 111 is within a preset range.

When the lengths of the heat pipe 21 are designed, thermal simulation is performed on a heat dissipation device (i.e., the prior art described below) in which cooling of the heating unit 31 is realized only by the liquid-cooling plate 1. A temperature ratio between the heating units 31 is calculated based on the thermal simulation, and the lengths of the corresponding heat pipes are designed based on the ratio. Specifically, the length ratio between the heat pipes 21 and the temperature ratio between the corresponding heating units 31 can be made to be the same (e.g., assuming that the ratio between any three heating units 31 is 117:121:122, the length ratio between the three heat pipes 21 corresponding to the three heating units 31 are also 117:121:122). Initial lengths of the heat pipes 21 are obtained, and the thermal simulation is performed on the heat dissipation device with the initial lengths of the heat pipes 21. If the difference between the temperature of a certain heating unit 31 and the temperature of other heating unit 31 is greater than the preset range, the length of the heat pipe 21 in contact with the overheating heating unit 31 is correspondingly increased until the temperature difference between the heating units 31 is within the preset range.

Specifically, as shown in FIG. 1, in the first row of the heat pipe assemblies 2, the length of the first heat pipe 21a of the first heat pipe assembly 2a is 130 mm, the length of the second heat pipe 21b of the first heat pipe assembly 2a is 170 mm, and the length of the third heat pipe 21c of the first heat pipe assembly 2a is 150 mm. The length of the first heat pipe 21a of the second heat pipe assembly 2b is 130 mm, the length of the second heat pipe 21b of the second heat pipe assembly 2b is 150 mm, and the length of the third heat pipe 21c of the second heat pipe assembly 2b is 190 mm. The length of the first heat pipe 21a of the third heat pipe assembly 2c is 240mm, the length of the second heat pipe 21b of the third heat pipe assembly 2c is 170 mm, and the length of the third heat pipe 21c of the third heat pipe assembly 2c is 130 mm.

In the second row of the heat pipe assembly 2, the length of the first heat pipe 21a of the first heat pipe assembly 2a is 130 mm, the length of the second heat pipe 21b of the first heat pipe assembly 2a is 170 mm, and the length of the third heat pipe 21c of the first heat pipe assembly 2a is 150 mm. The length of the first heat pipe 21a of the second heat pipe assembly 2b is 170 mm, the length of the second heat pipe 21b of the second heat pipe assembly 2b is 170 mm, and the length of the third heat pipe 21c of the second heat pipe assembly 2b is 190 mm. The length of the first heat pipe 21a of the third heat pipe assembly 2c is 240 mm, the length of the second heat pipe 21b of the third heat pipe assembly 2c is 170 mm, and the length of the third heat pipe 21c of the third heat pipe assembly 2c is 100 mm.

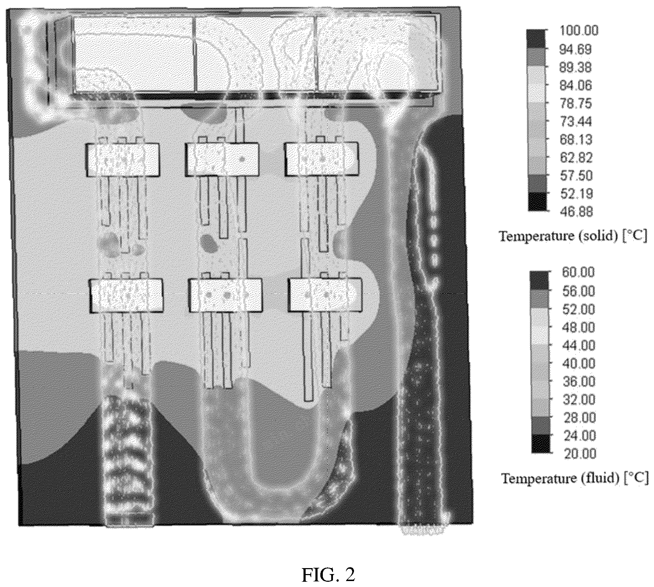

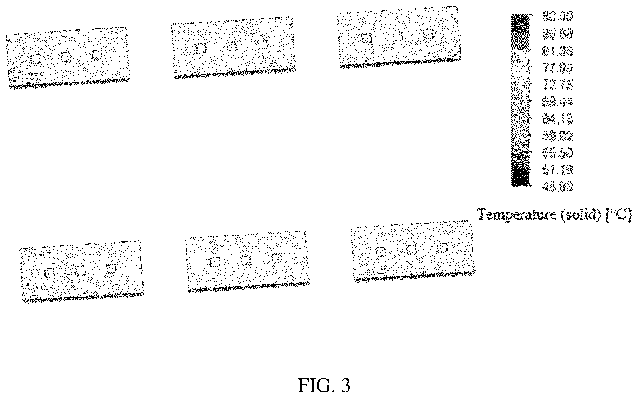

FIG. 2 and FIG. 3 are thermal simulation images of the heat dissipation device according to some embodiments of the present disclosure. It can be known from the thermal simulation images of the heat dissipation device according to the present disclosure:

In the first row of the heating elements 3 according to some embodiments of the present disclosure, the center temperature of a side of the first heating element 3a away from the liquid-cooling plate 1 is 90.20°C, the temperature of the first heating unit 31a of the first heating element 3a is 70.13° C, the temperature of the second heating unit 31b of the first heating element 3a is 71.73 °C, and the temperature of the third heating unit 31c of the first heating element 3a is 70.76°C. The center temperature of a side of the second heating element 3b away from the liquid-cooling plate 1 is 85.34° C, and the temperature of the first heating unit 31a of the second heating element 3b is 71.34°C, the temperature of the second heating unit 31b of the second heating element 3b is 70.67 °C, and the temperature of the third heating unit 31c of the second heating element 3b is 70.03 °C. The center temperature of a side of the third heating element 3c away from the liquid-cooling plate 1 is 90.68°C, the temperature of the first heating unit 31a of the third heating element 3c is 71.32°C, the temperature of the second heating unit 31b of the third heating element 3c is 71.52°C, and the temperature of the third heating unit 31c of the third heating element 3c is 70.83 °C.

In the second row of the heating elements 3 according to some embodiments of the present disclosure, the center temperature of a side of the first heating element 3a away from the liquid-cooling plate 1 is 85.45°C, the temperature of the first heating unit 31a of the first heating element 3a is 69.45°C, the temperature of the second heating unit 31b of the first heating element 3a is 71.25°C, and the temperature of the third heating unit 31c of the first heating element 3a is 71.42°C. The center temperature of a side of the second heating element 3b away from the liquid-cooling plate 1 is 87.42°C, the temperature of the first heating unit 31a of the second heating element 3b is 71.90°C, the temperature of the second heating unit 31b of the second heating element 3b is 72.19°C, and the temperature of the third heating unit 31c of the second heating element 3b is 71.93°C. The center temperature of a side of the third heating element 3c away from the liquid-cooling plate 1 is 86.36°C, the temperature of the first heating unit 31a of the third heating element 3c is 70.58°C, the temperature of the second heating unit 31b of the third heating element 3c is 71.06°C, and the temperature of the third heating unit 31c of the third heating element 3c is 70.55°C.

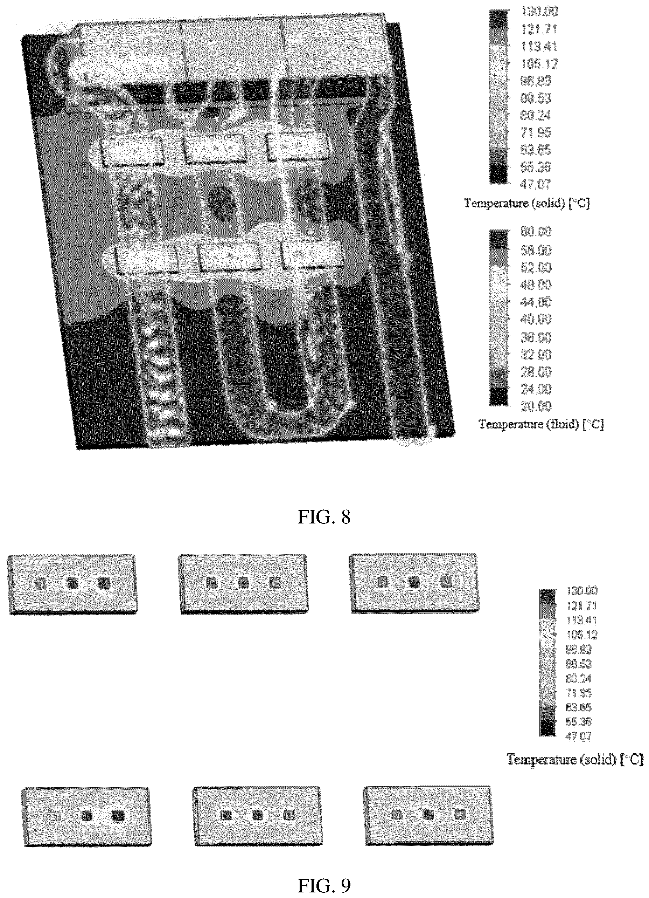

FIG. 8 and FIG. 9 are thermal simulation images of the existing heat dissipation device, and the existing heat dissipation device is cooled only by the liquid-cooling plate 1 without providing a heat pipe. It can be known from the thermal simulation images of the existing heat dissipation device:

In the first row of the heating elements of the existing heat dissipation device from left to right, the center temperature of a side of the first heating element away from the liquid-cooling plate 1 is 112.54°C, and the temperatures of the three heating units on the first heating element from left to right (corresponding to the first heating unit 31a, the second heating unit 31b and the third heating element 31c of the first heating element 3a in the present disclosure, respectively) are 117.52°C, 122.94°C and 124.96°C, respectively. The center temperature of a side of the second heating element away from the liquid-cooling plate 1 is 109.72°C, and the temperatures of the three heating units on the second heating element from left to right (corresponding to the first heating unit 31a, the second heating unit 31b and the third heating element 31c of the second heating element 3b in the present disclosure, respectively) are 120.98°C, 122.00°C and 118.87°C, respectively. The center temperature of a side of the third heating element away from the liquid-cooling plate 1 is 111.69°C, and the temperatures of the three heating units on the third heating element from left to right (corresponding to the first heating unit 31a, the second heating unit 31b and the third heating element 31c of the third heating element 3c in the present disclosure, respectively) are 120.70°C, 123.98°C and 117.84, respectively.

In the second row of the heating elements of the existing heat dissipation device from left to right, the center temperature of a side of the first heating element away from the liquid-cooling plate 1 is 109.13°C, and the temperatures of the three heating units on the first heating element from left to right are 114.88°C, 123.80°C and 129.47°C, respectively. The center temperature of a side of the second heating element away from the liquid-cooling plate 1 is 115.10°C, and the temperatures of the three heating units on the second heating element from left to right are 123.78°C, 123.39°C and 122.16°C, respectively. The center temperature of a side of the third heating element away from the liquid-cooling plate 1 is 114.73°C, and the temperatures of the three heating units on the third heating element from left to right are 119.55°C, 123.63°C and 118.79°C, respectively.

As can be seen from the comparison, the temperatures of the plurality of heating elements of the existing heat dissipation device substantially range from 114.88°C to 129.47°C. The temperatures of the heating elements 31 of the heat separation device according to some embodiments of the present disclosure substantially range from 69.45°C to 72.19°C. The heat dissipation device according to some embodiments of the present disclosure can effectively reduce the temperatures of the heating elements 3 and keep the temperature difference between every two heating units 31 within 3°C (i.e. the preset range).

It should be noted that although the point value (such as 90.20°C) is not shown on the drawing, the above temperature values are directly output by relevant equipment.

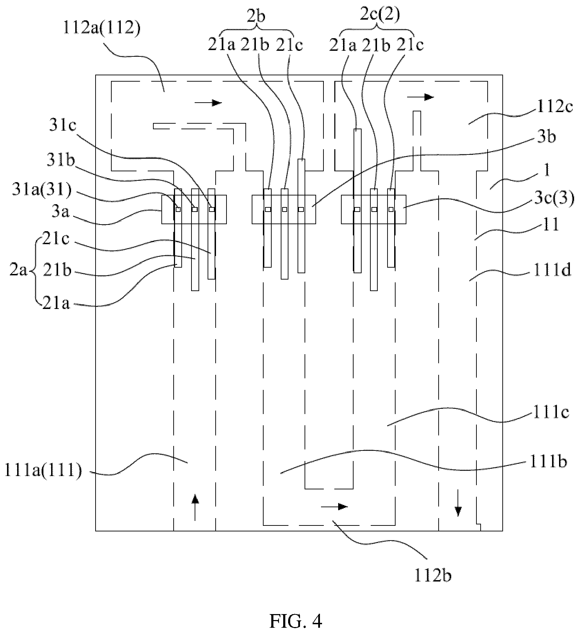

As shown in FIG. 4, in some embodiments, the arrangement of the liquid-cooling flow channel 11, the number and arrangement of the heating units 31 on each of the heating elements 3, the number and shape of the heat pipes 21 of each of the heat pipe assemblies 2, the corresponding relationship between the heat pipe assemblies 2 and the heating elements 3, the corresponding contact relationship between the heat pipes 21 of the heat pipe assembly 2 and the heating units 31 of the heating element 3, and the relationship (parallelism) between the extending direction of the main flow channel 111 and the extending direction of each heat pipe 21 are the same as those illustrated above, which is not repeated here.

Different from the above, three heating elements 3 and three heat pipe assemblies 2 are provided. One corresponding heat pipe assembly 2 is provided in each of the first main flow channel 111a, the second main flow channel 111b and the third main flow channel 111c, and the three heating elements 3 are in one-to-one correspondence with the three heat pipe assemblies 2.

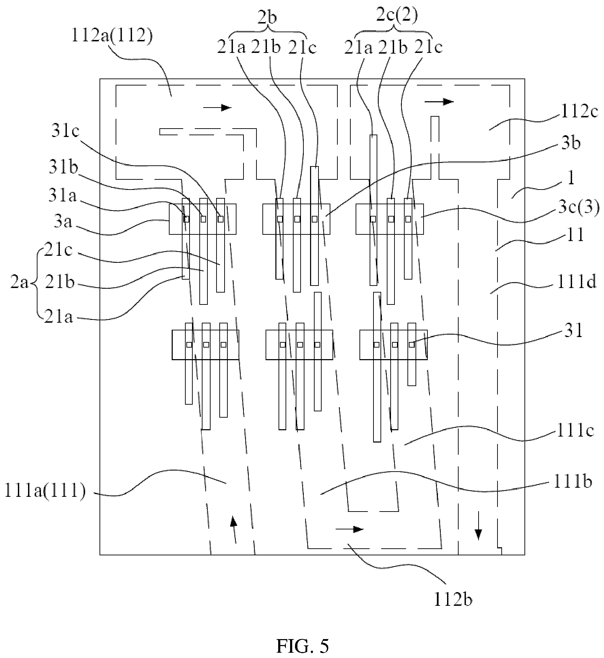

As shown in FIG. 5, in some embodiments, the number and arrangement of the heating elements 3, the number and arrangement of the heating units 31 on each of the heating elements 3, the number of the heat pipe assemblies 2, the number and shape of the heat pipes 21 of each of the heat pipe assemblies 2, the corresponding relationship between the heat pipe assemblies 2 and the heating elements 3, and the corresponding contact relationship between the heat pipes 21 of the heat pipe assembly 2 and the heating units 31 of the heating element 3 are the same as those illustrated above, which is not repeated here.

Different from the above, the extending direction of the main flow channel 111 intersects with the extending direction of each heat pipe 21. In this case, a portion of at least one heat pipe 21 can extend out of the liquid-cooling flow channel 11 to be in contact with a position on the liquid-cooling plate 1 where the liquid-cooling flow channel 11.

As shown in FIG. 6, in some embodiments, the number and arrangement of the heating elements 3, the number and arrangement of the heating units 31 on each of the heating elements 3, the number of the heat pipe assemblies 2, the number of the heat pipes 21 of each of the heat pipe assemblies 2, the corresponding relationship between the heat pipe assemblies 2 and the heating elements 3, the corresponding contact relationship between the heat pipes 21 of the heat pipe assembly 2 and the heating units 31 of the heating element 3, the arrangement of the liquid-cooling flow channel 11, and the relationship (parallelism) between the extending direction of the main flow channel 111 and the extending direction of each heat pipe 21 are the same as those illustrated above, which is not repeated here.

Different from the above, the heat pipe 21 is a bent pipe, and a portion of the heat pipe 21 is in contact with the liquid-cooling flow channel 11, another portion of the heat pipe 21 extends out of the liquid-cooling flow channel 11 to be in contact with the position on the liquid-cooling flow channel 11 where the liquid-cooling flow channel 11 is not provided.

The extending direction of the portion of the heat pipe 21 that is in contact with the liquid-cooling flow channel 11 is the same as the extending direction of the main flow channel 111, and the extending direction of the portion of the heat pipe 21 that extends out of the liquid-cooling flow channel 11 intersects with the extending direction of the main flow channel 111.

As shown in FIG. 7, in some embodiments, the number and arrangement of the heating elements 3, the number and arrangement of the heating units 31 on each of the heating elements 3, the number of the heat pipes 21 of each of the heat pipe assemblies 2, the arrangement of the liquid-cooling flow channel 11, and the relationship (parallelism) between the extending direction of the main flow channel 111 and the extending direction of each heat pipe 21 are the same as those illustrated above, which is not repeated here.

Different from the above, the number of the heat pipe assemblies 2 is equal to the number of columns of the heating elements 3, and three heat pipe assemblies 2 are provided. The three heat pipe assemblies 2 are respectively referred to as a first heat pipe assembly 2a, a second heat pipe assembly 2b and a third heat pipe assembly 2c. Each of the heat pipe assemblies 2 is arranged in contact with one respective column of heating elements 3. Specifically, the first heat pipe assembly 2a is arranged in contact with the two first heating elements 3a in the first column, the second heat pipe assembly 2b is arranged in contact with the two second heating elements 3b in the second column, and the third heat pipe assembly 2c is arranged in contact with the two third heating elements 3c in the third column.

The first heat pipe 21a of the first heat pipe assembly 2a is in contact with the first heating units 31a of the two first heating elements 3a. Since each of the first heating elements 3a is provided with one first heating unit 31a, and the first heat pipe assembly 2a is arranged in contact with the two first heating elements 3a, the first heat pipe 21a of the first heat pipe assembly 2a is simultaneously in contact with the two first heating units 31a. That is, the first heat pipe 21a of the first heat pipe assembly 2a is simultaneously in contact with the two first heating units 31a on the two first heating elements 3a.

Similarly, the second heat pipe 21b of the first heat pipe assembly 2a is in contact with the two second heating units 31b on two first heating elements 3a, and the third heat pipe 21c of the first heat pipe assembly 2a is in contact with the two third heating units 31c on two first heating elements 3a.

The first heat pipe 21a of the second heat pipe assembly 2b is simultaneously in contact with the two first heating units 31a on the two second heating elements 3b, the second heat pipe 21b of the second heat pipe assembly 2b is simultaneously in contact with the two second heating units 31b on two second heating elements 3b, and the third heat pipe 21c of the second heat pipe assembly 2b is simultaneously in contact with the two third heating units 31c on the two second heating elements 3b.

The first heat pipe 21a of the third heat pipe assembly 2c is simultaneously in contact with the two first heating units 31a on the two third heating element 3c, the second heat pipe 21b of the third heat pipe assembly 2c is simultaneously in contact with the two second heating units 31b on the two third heating elements 3c, and the third heat pipe 21c of the third heat pipe assembly 2c is simultaneously in contact with the two third heating units 31c on two third heating elements 3c.

The above are preferred embodiments of the present disclosure, and are not intended to limit the present disclosure. Any modification, equivalent substitution and improvement made within the spirit and principle of the present disclosure should fall within the protection scope of the present disclosure.

## Claims

1. A heat dissipation device for an energy storage converter, configured to dissipate heat from a plurality of heating elements (3), each heating element of the plurality of heating elements (3) including a respective plurality of heating units (31), the heat dissipation device comprising: a liquid-cooling plate (1) and a plurality of heat pipes (21) arranged in a plurality of heat pipe assemblies (2), and each heat pipe assembly of the plurality of heat pipe assemblies (2) including at least one respective heat pipe (21), wherein:
a respective heat pipe assembly of the plurality of heat pipe assemblies (2) is configured to be in contact with at least one corresponding heating element of the plurality of heating elements (3);
each heat pipe (21) of the respective heat pipe assembly is configured to be in contact with at least one heating unit (31) of the at least one corresponding heating element (3), each heating unit (31) of the at least one corresponding heating element (3) is in contact with at least one heat pipe (21) of the respective heat pipe assembly; and
the liquid-cooling plate (1) includes a liquid-cooling flow channel (11), and at least a portion of each heat pipe of the plurality of heat pipes (21) is in thermal contact with the liquid-cooling flow channel (11) and configured to transfer heat generated by the plurality of heating elements (3) to the liquid-cooling flow channel (11).

2. The heat dissipation device of claim 1, wherein each heat pipe of the plurality of heat pipes (21) has at least one of a configurable length or a configurable width, to enable control a temperature difference between every two heating units within a preset range of each other among the respective plurality of heating units (31).

3. The heat dissipation device of claim 2, wherein the plurality of heat pipe assemblies (2) are arranged at intervals along a flowing direction of liquid in the liquid-cooling flow channel (11), and the one respective heat pipe assembly of the plurality of heat pipe assemblies (2) is arranged in contact with a same number of corresponding heating elements of the plurality of heating elements (3).

4. The heat dissipation device of claim 3, wherein the liquid-cooling flow channel (11) includes a plurality of main flow channels (111) arranged at intervals and at least one connecting flow channel (112), every two adjacent main flow channels (111) are in communication with each other through one respective connecting flow channel (112), each respective main flow channel of the plurality of main flow channels (111) is provided with at least one corresponding heat pipe assembly of the plurality of heat pipe assemblies (2), and at least a portion of each heat pipe of heat pipes (21) of the at least one corresponding heat pipe assembly is in contact with the each respective main flow channel.

5. The heat dissipation device of claim 4, wherein the liquid-cooling flow channel (11) includes a first main flow channel (111a), a second main flow channel (111b), a third main flow channel (111c) and a fourth main flow channel (111d), and includes a first connecting flow channel (112a), a second connecting flow channel (112b) and a third connecting flow channel (112c);
wherein the first connecting flow channel (112a) is connected between the first main flow channel (111a) and the second main flow channel (111b), the second connecting flow channel (112b) is connected between the second main flow channel (111b) and the third main flow channel (111c), and the third connecting flow channel (112c) is connected between the third main flow channel (111c) and the fourth main flow channel (111d);
the first main flow channel (111a) is configured to feed the liquid, and the fourth main flow channel (111d) is configured to discharge the liquid; and
each of the first main flow channel (111a), the second main flow channel (111b) and the third main flow channel (111c) is provided with at least one corresponding heat pipe assembly of the plurality of heat pipe assemblies (2).

6. The heat dissipation device of claim 5, wherein the plurality of heat pipe assemblies (2) include a first heat pipe assembly (2a), a second heat pipe assembly (2b) and a third heat pipe assembly (2c);
wherein the first main flow channel (111a) is provided with the first heat pipe assembly (2a), the second main flow channel (111b) is provided with the second heat pipe assembly (2b), and the third main flow channel (111c) is provided with the third heat pipe assembly (2c);
wherein the plurality of heating elements (3) include a first heating element (3a), a second heating element (3b) and a third heating element (3c); and
wherein the first heat pipe assembly (2a) is arranged in contact with the first heating element (3a), the second heat pipe assembly (2b) is arranged in contact with the second heating element (3b), and the third heat pipe assembly (2c) is arranged in contact with the third heating element (3c).

7. The heat dissipation device of claim 6, wherein the first main flow channel (111a), the second main flow channel (111b), the third main flow channel (111c) and the fourth main flow channel (111d) are arranged at intervals along a preset direction;
the respective plurality of heating units (31) arranged on each heating element of the plurality of heating elements (3) are arranged in a single row along the preset direction;
each heat pipe assembly of the plurality of heat pipe assemblies (2) includes a plurality of heat pipes (21) arranged at intervals along the preset direction, and a number of heat pipes (21) of each heat pipe assembly of the plurality of heat pipe assemblies (2) is equal to a number of heating units (31) on each heating element of the plurality of heating elements (3); and
heat pipes (21) of the one respective heat pipe assembly of the plurality of heat pipe assemblies (2) are arranged in one-to-one contact with heating units (31) on a corresponding heating element of the plurality of heating elements (3).

8. The heat dissipation device of claim 7, wherein two heating units (31) are arranged on each heating element of the plurality of heating elements (3), and each heat pipe assembly of the plurality of heat pipe assemblies (2) includes two heat pipes (21);
one heat pipe (21) of the first heat pipe assembly (2a) closer to the second main flow channel (111b) has a length greater than a length of an other heat pipe (21) of the first heat pipe assembly (2a);
one heat pipe (21) of the second heat pipe assembly (2b) closer to the third main flow channel (111c) has a length greater than a length of an other heat pipe (21) of the second heat pipe assembly (2b) closer to the first main flow channel (111a); and
one heat pipe (21) of the third heat pipe assembly (2c) closer to the fourth main flow channel (111d) has a length less than a length of an other heat pipe (21) of the third heat pipe assembly (2c) closer to the third main flow channel (111c).

9. The heat dissipation device of claim 7, wherein three or more heating units (31) are arranged on each heating element of the plurality of heating elements (3), and each heat pipe assembly of the plurality of heat pipe assemblies (2) includes three or more heat pipes (21);
a heat pipe (21) of the first heat pipe assembly (2a) closest to the second main flow channel (111b) has a length greater than a length of a heat pipe (21) of the first heat pipe assembly (2a) most far away from the second main flow channel (111b), and a remaining heat pipe (21) of the first heat pipe assembly (2a) has a length greater than the length of the heat pipe (21) closest to the second main flow channel (111b);
one heat pipe (21) of every two adjacent heat pipes of the second heat pipe assembly (2b) closer to the third main flow channel (1 1 1c) has a length greater than or equal to a length of an other heat pipe (21) closer to the first main flow channel (111a); and
one heat pipe (21) of every two adjacent heat pipes of the third heat pipe assembly (2c) closer to the fourth main flow channel (111d) has a length less than a length of an other heat pipe (21) closer to the third main flow channel (111c).

10. The heat dissipation device of claim 8, wherein a heat pipe (21) of the second heat pipe assembly (2b) closer to the first main flow channel (111a) has a length greater than or equal to a length of a heat pipe (21) of the first heat pipe assembly (2a) farther away from the second main flow channel (111b);
a heat pipe (21) of the second heat pipe assembly (2b) closer to the third main flow channel (111c) has a length greater than a length of a heat pipe (21) of the first heat pipe assembly (2a) closer to the second main flow channel (111b);
a heat pipe (21) of the third heat pipe assembly (2c) closer to the second main flow channel (11 1b) has a length greater than a length of a heat pipe (21) of the second heat pipe assembly (2b) closer to the third main flow channel (111c); and
a heat pipe (21) of the third heat pipe assembly (2c) closer to the fourth main flow channel (111d) has a length less than a length of a heat pipe (21) of the second heat pipe assembly (2b) closer to the third main flow channel (111c).

11. The heat dissipation device of claim 9, wherein a heat pipe (21) of the second heat pipe assembly (2b) closer or closest to the first main flow channel (111a) has a length greater than or equal to a length of a heat pipe (21) of the first heat pipe assembly (2a) more or most far away from the second main flow channel (111b);
a heat pipe (21) of the second heat pipe assembly (2b) closer or closest to the third main flow channel (111c) has a length greater than a length of a heat pipe (21) of the first heat pipe assembly (2a) closer or closest to the second main flow channel (111b);
a heat pipe (21) of the third heat pipe assembly (2c) closer or closest to the second main flow channel (111b) has a length greater than a length of a heat pipe (21) of the second heat pipe assembly (2b) closer or closest to the third main flow channel (111c); and
a heat pipe (21) of the third heat pipe assembly (2c) closer or closest to the fourth main flow channel (111d) has a length less than a length of a heat pipe (21) of the second heat pipe assembly (2b) closer or closest to the third main flow channel (111c).

12. The heat dissipation device of claim 11, wherein each heating element of the plurality of heating elements (3) is provided with a first heating unit (31a), a second heating unit (31b) and a third heating unit (31c) arranged at intervals along the preset direction in a single row;
each heat pipe assembly of the plurality of heat pipe assemblies (2) includes a first heat pipe (21a), a second heat pipe (21b) and a third heat pipe (21c) arranged at intervals along the preset direction;
the first heating unit (31a) of the one respective heat pipe assembly of the plurality of heat pipe assemblies (2) is in contact with the first heat pipe (21a) of one corresponding heating element of the plurality of heating elements (3), the second heating unit (31b) of the one respective heat pipe assembly is in contact with the second heat pipe (21b) of the one corresponding heating element, and the third heating unit (31c) of the one respective heat pipe assembly is in contact with the third heat pipe (21c) of the one corresponding heating element;
the third heat pipe (21c) of the first heat pipe assembly (2a) has a length greater than a length of the first heat pipe (21a) of the first heat pipe assembly (2a), and the second heat pipe (21b) of the first heat pipe assembly (2a) has a length greater than the length of the third heat pipe (21c) of the first heat pipe assembly (2a);
the second heat pipe (21b) of the second heat pipe assembly (2b) has a length greater than or equal to a length of the first heat pipe (21a) of the second heat pipe assembly (2b), and the third heat pipe (21c) of the second heat pipe assembly (2b) has a length greater than the length of the second heat pipe (21b) of the second heat pipe assembly (2b);
the third heat pipe (21c) of the third heat pipe assembly (2c) has a length less than a length of the second heat pipe (21b) of the third heat pipe assembly (2c), and the first heat pipe (21a) of the third heat pipe assembly (2c) has a length greater than or equal to the length of the second heat pipe (21b) of the third heat pipe assembly (2c);
the length of the first heat pipe (21a) of the second heat pipe assembly (2b) is greater than or equal to the length of the first heat pipe (21a) of the first heat pipe assembly (2a);
the length of the third heat pipe (21c) of the second heat pipe assembly (2b) is greater than the length of the third heat pipe (21c) of the first heat pipe assembly (2a);
the length of the first heat pipe (21a) of the third heat pipe assembly (2c) is greater than the length of the third heat pipe (21c) of the second heat pipe assembly (2b); and
the length of the third heat pipe (21c) of the third heat pipe assembly (2c) is less than the length of the third heat pipe (21c) of the second heat pipe assembly (2b).

13. The heat dissipation device of claim 4, wherein the plurality of heating elements (3) are arranged in multiple rows and multiple columns, a number of the plurality of heat pipe assemblies (2) is equal to a number of the plurality of the heating elements (3), and the plurality of the heat pipe assemblies (2) are in one-to-one correspondence with the plurality of heating elements (3);
each respective main flow channel of the plurality of main flow channels (111) is provided with at least two corresponding heat pipe assemblies of the plurality of heat pipe assemblies (2);
each heat pipe (21) of a heat pipe assembly of the at least two corresponding heat pipe assemblies (2) closer or closest to a liquid outlet of the liquid-cooling flow channel (11) has a respective length greater than or equal to a respective length of each heat pipe (21) of a heat pipe assembly of the at least two corresponding heat pipe assemblies (2) closer or closest to a liquid inlet of the liquid-cooling flow channel (11).

14. The heat dissipation device of claim 3, wherein the plurality of heating elements (3) are arranged in rows and columns;
a number of the plurality of heat pipe assemblies (2) is equal to a number of the columns of the plurality of heating elements (3);
heating elements of the plurality of heating elements (3) in a same column are arranged in contact with a corresponding heat pipe assembly of the plurality of heat pipe assemblies (2), and each heat pipe assembly of the plurality of heat pipe assemblies (2) is arranged in contact with one respective column of heating elements.

15. The heat dissipation device of claim 14, wherein the respective plurality of heating units (31) arranged on each heating element of the plurality of heating elements (3) are arranged in rows and columns;
a number of the at least one respective heat pipes (21) of each heat pipe assembly of the plurality of heat pipe assemblies (2) is equal to a number of the columns of the respective plurality of heating units (31) arranged on each heating element of the plurality of heating elements (3);
each column of heating units (31) arranged on the at least one corresponding heating element of the plurality of heating elements (3) is in contact with one respective heat pipe (21) of the one respective heat pipe assembly of the plurality of heat pipe assemblies (2), and each heat pipe (21) of the one respective heat pipe assembly is in contact with one respective column of heating units (31) arranged on the at least one corresponding heating element.
